# EUROPEAN PATENT APPLICATION

(11) **EP 1 580 788 A2**
(43) Date of publication of application: **28.09.2005**
(21) Application number: 04256214.0
(22) Date of filing: 07.10.2004
(51) Int. Cl.: H01J 37/08, H01J 27/02

(54) **Cathode and counter-cathode arrangement in an ion source**

(30) Priority: 24.10.2003 GB 0324871
(71) Applicant: APPLIED MATERIALS, INC., California 95054 (US)
(72) Inventor: Murrell, Adrian John, Horsham, West Sussex RH12 4BS (GB); Goldberg, Richard David, Hove, East Sussex BN3 3AG (GB)
(74) Representative: Cross, Rupert Edward Blount

(57) **Abstract**

The present invention relates to ion sources comprising a cathode and a counter-cathode that are suitable for ion implanters.

The present invention provides an ion source comprising a vacuum chamber; an arc chamber operable to generate and contain a plasma; a cathode operable to emit electrons into the arc chamber along an electron path; a counter-cathode disposed in the electron path; respective separate electrical connections from each of the cathode and the counter-cathode including respective vacuum feedthroughs to outside the vacuum chamber; and a voltage potential adjuster located outside the vacuum chamber that is connected at least to the counter-cathode via the vacuum feed-through and is operable to alter the potential of the counter-cathode relative to the cathode.

## Description

### Field of the Invention

The present invention relates to ion sources comprising a cathode and a counter-cathode that are suitable for ion implanters.

### Background of the Invention

A contemplated application of the present invention is in an ion implanter that may be used in the manufacture of semiconductor devices or other materials, although many other applications are possible. In such an application, semiconductor wafers are modified by implanting atoms of desired dopant species into the body of the wafer to form regions of varying conductivity. Examples of common dopants are boron, phosphorus, arsenic and antimony.

Typically, an ion implanter contains an ion source held under vacuum within a vacuum chamber. The ion source produces ions using a plasma generated within an arc chamber. Plasma ions are extracted from the arc chamber and passed through a mass analysis stage such that ions of a desired mass are selected to travel onward to strike a semiconductor wafer. A more detailed description of an ion implanter can be found in US Patent No. 4,754,200.

In a typical Bernas-type source, thermal electrons are emitted from a cathode and are constrained by a magnetic field to travel along electron paths towards a counter-cathode. Interactions with precursor gas molecules within the arc chamber produces the desired plasma.

In one known arrangement, the counter-cathode is connected to the cathode such that they are at a common potential (US Patent Nos. 5,517,077 and 5,977,552). The counter-cathode repels electrons travelling from the cathode, increasing ionisation efficiency in the arc chamber.

In another known arrangement, the counter-cathode is electrically isolated so that it floats to the potential of the plasma (US Patent No. 5,703,372).

The mass analysis stage of the implanter is operated by control of a magnetic field to allow selection of ions of a desired mass (via their momentum to charge-state ratio) and rejection of unwanted ions (to the extent that they follow a different path in the magnetic field). In the case of boron doping for example, BF₃ is normally used as a precursor gas. Dissociation in the arc chamber results in a plasma typically containing B⁺, BF⁺ and BF₂⁺ ions . This mixture of ions is extracted and enters the mass analysis stage which ensures that only the preferred B/BFₓ species is delivered to the semiconductor wafer. Although many implant recipes require B⁺ ions to be implanted, others use BF₂⁺ ions. Because the BF₂⁺ ions dissociate on impact with a semiconductor wafer, the resulting boron atoms are implanted with reduced energy yielding shallower doping layers as is required in some applications.

### Summary of the Invention

An object of this invention is to increase the flexibility of operation of an ion source, for example to optimise the source for implanting different species derivable from a common source material or to optimise the output of a specific ion species from a particular feed material.

From a first aspect, the present invention resides in an ion source comprising a vacuum chamber; an arc chamber operable to generate and contain a plasma; a cathode operable to emit electrons into the arc chamber along an electron path; a counter-cathode disposed in the electron path; respective separate electrical connections from each of the cathode and the counter-cathode including respective vacuum feedthroughs to outside the vacuum chamber and a voltage potential adjuster located outside the vacuum chamber that is connected at least to the counter-cathode via the vacuum feed through and is operable to alter the potential of the counter-cathode relative to the cathode.

The term voltage potential adjuster should be construed broadly to include any type of component that is operable to alter the potential of the counter-cathode relative to the cathode. For example, the voltage potential adjuster may comprise one or more of a switch, a variable resistor, a power supply or a potential divider.

In this way, the potential of the counter-cathode can be varied such that its effectiveness in reflecting electrons can be adjusted. For example, if the counter-cathode is held at the same potential as the cathode, the lifetimes in the arc chamber of the electrons emitted by the cathode are increased to produce a more intense plasma, enhancing ionisation and cracking of the source gas molecules. Alternatively, the counter-cathode may be set to a different potential or may be allowed to float, whereupon the lifetime of electrons capable of causing ionization and molecular cracking are decreased within the arc chamber. This may be advantageous where a relatively low plasma intensity is required and it is desired to limit cracking of the source gas molecules. Hence, control of the ion source in this way allows the relative concentrations of ion species in the arc chamber, and delivered to the mass analysis stage in an ion implanter, to be controlled. This is particularly useful, for example, in boron implantation where operation of the ion source can be adapted to suit the use of B⁺, BF⁺ or BF₂⁺ ions, as required.

The voltage potential adjuster may be operable to make or break electrical contact between the cathode and the counter-cathode. Optionally, the ion source is arranged such that the voltage potential adjuster is operable to isolate electrically the counter-cathode when set to break electrical contact between the cathode and the counter-cathode. This is convenient as it allows the counter-cathode to float to a potential set by the plasma.

Optionally, the voltage potential adjuster is operable to select the potential of the counter-cathode relative to the cathode. The voltage potential adjuster may comprise at least one of the group comprising a switch, a variable resistor, a power supply and a potential divider. Where a power supply is used, potentials on the counter-cathode not intermediate between floating and the cathode potential are possible.

The present invention may be used with any ion source type containing both a cathode and a counter cathode reflector or repeller.

Often the ion source further comprises a magnet assembly arranged to provide a magnetic field in the arc chamber to define the electron path, although such a magnet arrangement is by no means necessary. This provides a longer electron path length for the thermal electrons that may otherwise be attracted directly to the adjacent arc chamber walls. The magnetic field constrains the electrons to pass along the length of the arc chamber where, for example, cathode and counter-cathode are located at opposed ends of the arc chamber.

From a second aspect, the present invention resides in an ion implanter comprising an ion source as described above, wherein the arc chamber further comprises an exit aperture and the ion implanter further comprises an extraction electrode operable to extract ions from the plasma contained within the arc chamber through the exit aperture, a mass analysis stage located to receive ions extracted from the arc chamber and operable to deliver ions of a selected mass and charge state, at a particular energy, for implanting into a target.

A further aspect of the invention provides a method of operating an ion source as described above comprising the steps of setting potentials across the cathode and anode; setting the voltage potential adjuster to place a desired potential across the counter-cathode; filling the arc chamber with gas; and heating the cathode sufficiently to cause emission of electrons.

### Brief Description of the Drawings

Figure 1 is a schematic representation of an ion implanter;
Figure 2 is a side view of a first ion source;
Figure 3 is a side view of a second ion source that comprises an indirectly-heated cathode arrangement;
Figure 4 is a simplified representation of an ion source with an indirectly-heated cathode arrangement, showing a biasing arrangement according to a first embodiment of the present invention; and
Figure 5 is a simplified representation of an ion source with a simple filament arrangement showing a biasing arrangement according to a second embodiment of the present invention.

### Detailed Description of the Invention

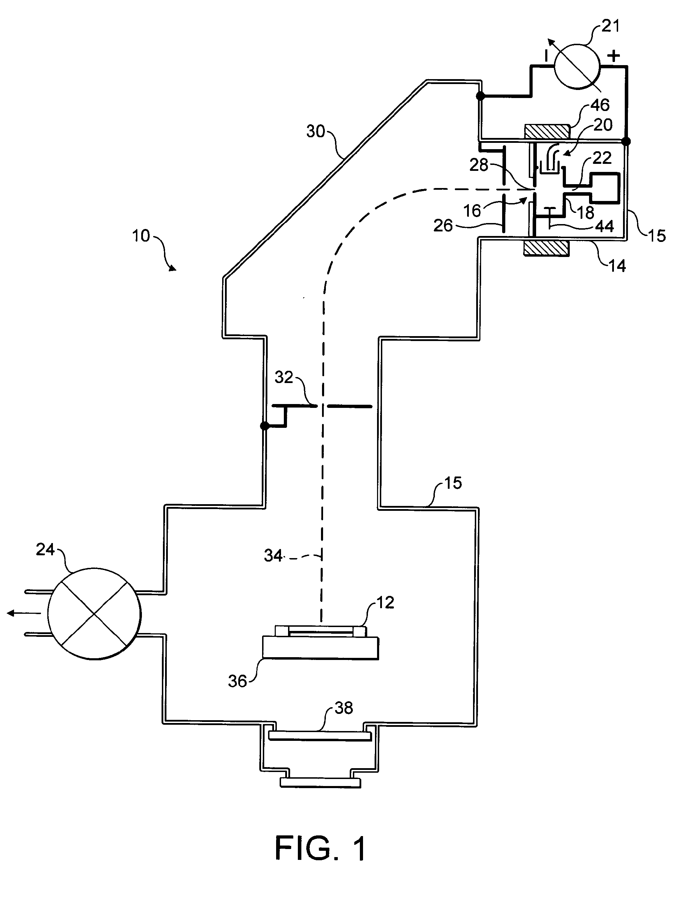

In order to provide a context for the present invention, an exemplary application is shown in Figure 1, although it will be appreciated that this is merely an example of an application of the present invention and is in no way limiting.

Figure 1 shows an ion implanter 10 for implanting ions in semiconductor wafers 12 including an ion source 14 according to the present invention. Ions are generated by the ion source 14 to be extracted and passed through a mass analysis stage 30. Ions of a desired mass are selected to pass through a mass-resolving slit 32 and then to strike a semiconductor wafer 12.

The ion implanter 10 contains an ion source 14 for generating an ion beam of a desired species that is located within a vacuum chamber 15. The ion source 14 generally comprises an arc chamber 16 containing a cathode 20 located at one end thereof and an anode that is provided by the walls 18 of the arc chamber 16. The cathode 20 is heated sufficiently to generate thermal electrons.

Thermal electrons emitted by the cathode 20 are of course attracted to the anode, i.e. the adjacent chamber walls 18. The thermal electrons ionise gas molecules as they traverse the arc chamber 16, thereby forming a plasma and generating the desired ions.

The path followed by the thermal electrons is controlled to prevent the electrons merely following the shortest path to the chamber walls 18. A magnet assembly 46 provides a magnetic field extending through the arc chamber 16 such that thermal electrons follow a spiral path along the length of the arc chamber 16 towards a counter-cathode 44 located at the opposite end of the arc chamber 16.

A gas feed 22 fills the arc chamber 16 with a precursor gas species, BF₃ in this case. The arc chamber 16 held at a reduced pressure by the vacuum chamber 15. The thermal electrons travelling through the arc chamber 16 ionise the precursor BF₃ gas molecules and also crack the BF₃ molecules to form BF₂, BF and B molecules and ions. The ions created in the plasma will also contain trace amounts of contaminant ions (e.g. generated from the material of the chamber walls).

The ion source 14 (including the magnet assembly 46) is shown rotated by 90° in Figure 1 compared to our actual ion implanter 10. In fact, the cathode 20 and counter-cathode 44 are aligned on an axis perpendicular to the plane of the page, but have been illustrated in a rotated arrangement for the sake of clarity.

Ions from within the arc chamber 16 are extracted through an exit aperture 28 using a negatively-biased extraction electrode 26. A potential difference is applied between the ion source 14 and the following mass analysis stage 30 by a power supply 21 to accelerate extracted ions, the ion source 14 and mass analysis stage 30 being electrically isolated from each other by an insulator (not shown). The mixture of extracted ions are then passed through the mass analysis stage 30 so that they pass around a curved path under the influence of a magnetic field. The radius of curvature travelled by any ion is determined by its mass, charge state and energy and the magnetic field is controlled so that, for a set beam energy, only those ions with a desired mass and charge state exit along a path coincident with the mass-resolving slit 32. The emergent ion beam is then transported to the target, i.e. the substrate wafer 12 to be implanted or a beam stop 38 when there is no wafer 12 in the target position. In other modes, the beam may also be decelerated using a lens assembly positioned between the mass analysis stage 30 and the target position.

The semiconductor wafer 12 will be one of many positioned on a carousel 36 that rotates to present the wafers 12 to the incident ion beam in turn. In addition, the rotating carousel 36 may be translated from side to side thereby allowing the incident ions to be scanned across each wafer 12. As the wafers 12 are being rotated, there will be times when the ion beam will not be incident on a wafer 12 and so the ions will continue beyond the target position to strike a beam stop 38. In an alternative arrangement, a single wafer 12 may be mounted and presented for implantation.

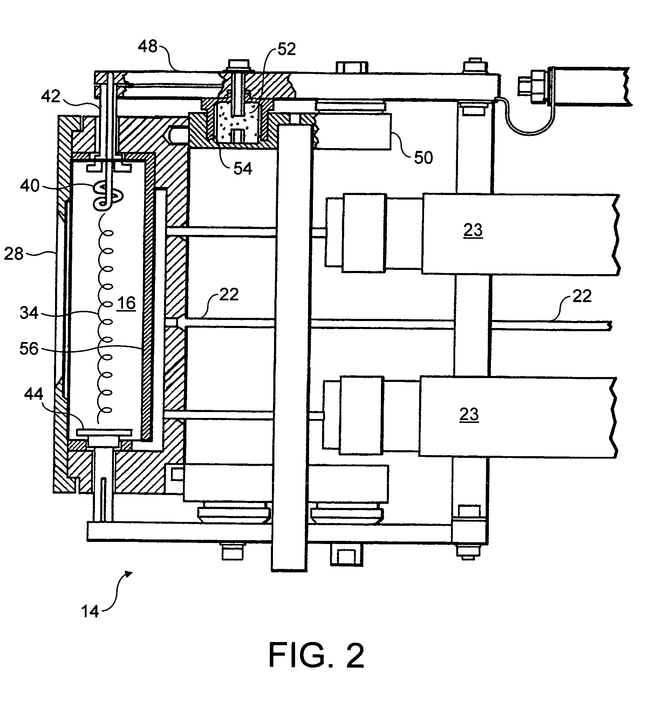

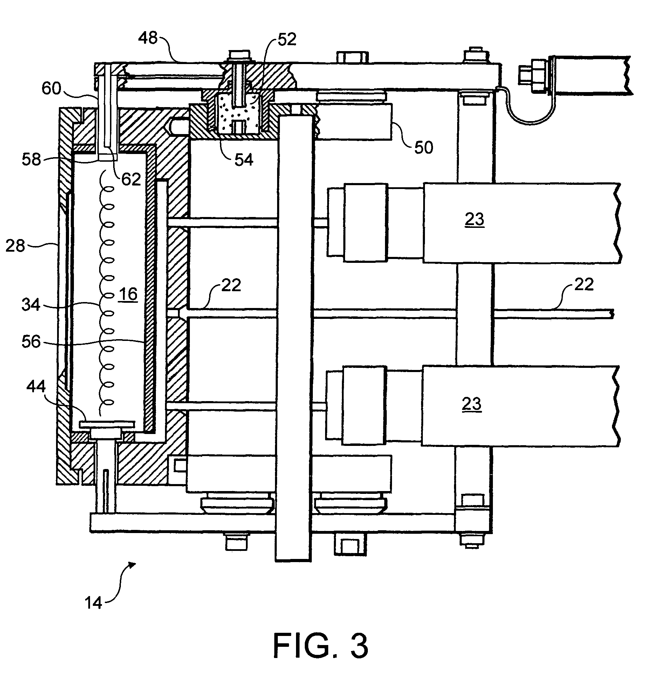

Figures 2 and 3 show two ion sources 14 that may be used in the ion implanter 10 of Figure 1 in greater detail: Figure 2 corresponds to a filament arrangement and Figure 3 corresponds to an indirectly-heated cathode arrangement.

Referring first to Figure 2, a filament 40 that acts as a cathode is situated at one end of the arc chamber 16 to sit in front of an electron reflector 42. The electron reflector 42 is held at the same negative potential as the filament 40 such that they both repel electrons. There is a small gap between the electron reflector 42 and a liner 56 that comprises the innermost part of the arc chamber 16. This gap ensures that the electron reflector 42 is electrically isolated from the liner 56 that acts as an anode. The clearance is minimal to avoid loss of the precursor gas from the arc chamber 16. A counter-cathode 44 is located at the far end of the arc chamber 16, again with a small separation from the liner 56 to ensure electrical isolation and to minimise gas leakage. A magnet assembly 46 (shown only in Figure 1) is operable to provide a magnetic field that causes electrons emitted from the filament 40 to follow a spiral path 34 along the length of the arc chamber 16 towards the counter-cathode 44. The arc chamber 16 is filled with the precursor gas species by a gas feed 22 or by one or more vaporisers 23 that may heat a solid or liquid.

The filament 40 is held in place by two clamps 48 that are each connected to the body 50 of the ion source 14 using an insulating block 52. The insulating block 52 is fitted with a shield 54 to prevent any gas molecules escaping from the arc chamber 16 from reaching the insulator block.

As will be evident, Figure 3 corresponds largely to Figure 2 and so like parts will not be described again for the sake of brevity. In addition, like reference numerals are used for like parts.

The difference between Figure 2 and Figure 3 lies in the top of the arc chamber 16 where Figure 3 shows an indirectly-heated cathode arrangement. A cathode is provided by an end cap 58 of a tube 60 that projects slightly into the arc chamber 16, the tube 60 containing a heating filament 62. The heating filament 62 and end cap 58 are kept at different potentials to ensure thermal electrons emitted by the filament 62 are accelerated into the end cap 58, and a gap is left between the tube 60 and the liner 56 of the arc chamber 16 to maintain electrical isolation. Acceleration of electrons into the end cap 58 transfers energy to the end cap 58 such that it heats up sufficiently to emit thermal electrons into the arc chamber 16.

This arrangement is an improvement over the filament arrangement of Figure 3 because the filament 40 is corroded quickly by the plasma's reactive ions and through ion bombardment. In order to alleviate this problem, the heating filament 62 of the indirectly-heated cathode is housed within the enclosed tube 60 such that ions do not come into contact with the heating filament 62.

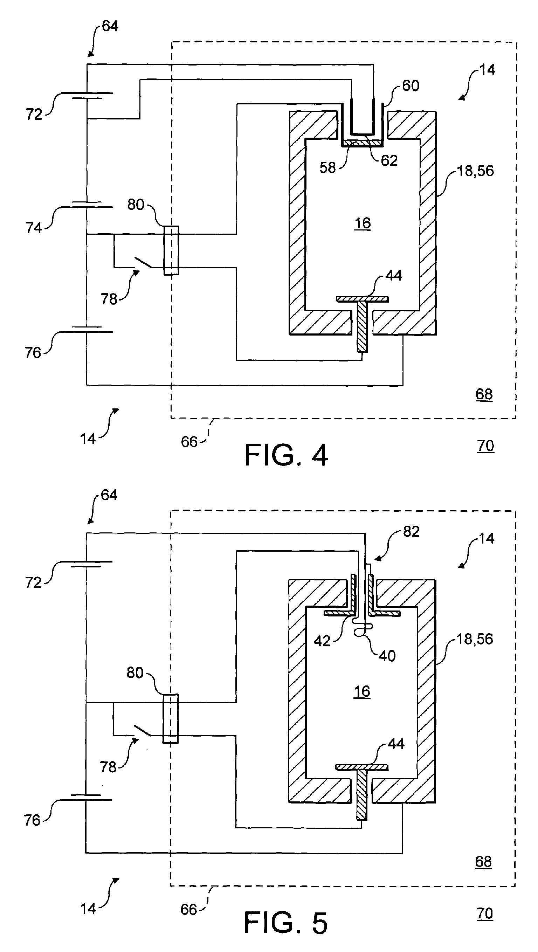

Turning now to Figure 4, a simplified representation of the arc chamber 16 of Figure 3 alongside an electrical power supply 64 is shown. The dashed box 66 indicates the boundary between components that are housed within the vacuum chamber 15 and those components that are situated in atmosphere 70. Clearly, components located in atmosphere 70 can be readily adjusted without the need to break vacuum 68.

As can be seen from Figure 4, a series of three power supplies located in atmosphere 70 provide electrical current to various components of the ion source 14 at different potentials. A filament supply 72 provides a relatively high current to the filament 62. A bias supply 74 is used to set a potential on the end cap 58 that is positive with respect to the filament 62 such that thermal electrons emitted from the filament 62 are accelerated towards the end cap 58. An arc supply 76 maintains the walls 18 (i.e. the liner 56) of the arc chamber 16 at a positive potential with respect to the end cap 58.

There is also an electrical connection provided to the counter-cathode 44 that passes through a vacuum feed through 80 at the vacuum/atmosphere boundary 66 to join the arc supply 76 via a control relay 78. The control relay 78 allows electrical connection to be made and broken without the need to vent the vacuum chamber 15 to atmosphere 70. When the control relay 78 is closed, the counter-cathode 44 is tied to the same potential as the end cap 58 thereby ensuring that electrons travelling toward the counter-cathode 44 are repelled to pass back through the arc chamber 16 and so have an increased chance of ionising pre-cursor gas molecules and cracking feed materials. When the control relay 78 is open, the counter-cathode 44 is free to float to the potential of the plasma within the arc chamber 16. This means that electrons are no longer reflected as strongly by the counter-cathode 44.

When a tied potential arrangement is used, the chance of cracking BF₃ molecules in the arc chamber 16 is increased due to the higher electron density in the arc chamber 16. Accordingly, the percentage of boron ions in the plasma relative to the total of other ion types increases (e.g. BF and BF₂ ions). When the counter-cathode 44 is isolated and allowed to float to a potential set by the plasma, cracking is reduced such that more molecular ions (e.g. BF⁺ and/or BF₂⁺) remain in the plasma. As described previously, either boron or BF₂⁺ ions may be preferred for ion implantation of semiconductor wafers 12. Switching the potential of the counter-cathode 44 maximises the number of preferred ions incident on the mass analysis stage 30 and hence available for onward transmission to the semiconductor wafer 12. Therefore, the tied potential arrangement is better used for implantation using boron ions and the floating arrangement is better used for implantation using BF₂⁺ ions.

Figure 5 corresponds broadly to Figure 4 and so like parts will not be described again for the sake of brevity. In addition, like parts are assigned like reference numerals.

Figure 5 shows an arrangement akin to Figure 4 but having a filament 40 rather than an indirectly-heated cathode. The ion source 14 of Figures 2 and 5 comprises a filament 40 located in front of an electron reflector 42. The filament 40 and electron reflector 42 are held at a common negative potential at all times via an electrical connection 82 that can be made within vacuum 68. In addition, there is no need for a separate bias supply 74 as there is no potential difference between filament 40 and electron reflector 42. Accordingly, a single arc supply 76 sets the potentials of the electron reflector 42 and the filament 40 with respect to the walls 18 (or liner 56).

Otherwise, the embodiment of Figure 5 corresponds to the embodiment of Figure 4. Accordingly, the counter-cathode 44 may be either tied to the common negative voltage of the filament 40 and electron reflector 42 or may float to a potential set by the plasma depending upon whether the control relay 78 is closed or open, respectively.

The skilled person will appreciate that variations can be made to the above embodiments without departing from the scope of the present invention.

Whilst the above embodiments use a control relay 78 as a switch to allow the counter-cathode 44 to be connected or disconnected from the arc supply 76, other arrangements are possible. For example, a switch may be used to connect the counter-cathode 44 to either the cathode 20 or an alternative power supply. The alternative power supply may be one of those show in Figures 4 and 5 or it may be a further power supply. A further alternative would be a potential divider connected to provide a divided voltage potential and a switch operable to connect the counter-cathode 44 to one of the cathode 20 or the divided voltage potential. Still further, a variable resistance or variable potentiometer may be used to supply a selected voltage to the counter cathode 44.

The example of a control relay 78 is but a preferred form of switching arrangement, and the switch can be implemented in any number of standard ways.

Clearly the materials used in the construction of the ion source 14 and the particular arrangement of components can be chosen as required.

Whilst the above embodiments present the invention in the context of an ion source 14 of an ion implanter 10, the present invention can be used in many other applications such as an ion shower system, in which ions that are extracted from the ion source 14 are implanted into a target without undergoing mass analysis, or any other ion source 14 utilising a counter-cathode 44 in which selective ionization and/or molecular cracking are desirable.

## Claims

1. An ion source comprising:
a vacuum chamber;
an arc chamber operable to generate and contain a plasma;
a cathode operable to emit electrons into the arc chamber along an electron path;
a counter-cathode disposed in the electron path;
respective separate electrical connections from each of the cathode and the counter-cathode including respective vacuum feedthroughs to outside the vacuum chamber; and
a voltage potential adjuster located outside the vacuum chamber that is connected at least to the counter-cathode via the vacuum feed-through and is operable to alter the potential of the counter-cathode relative to the cathode.

2. An ion source according to claim 1, wherein the voltage potential adjuster is operable to make and break electrical contact between the cathode and counter-cathode.

3. An ion source according to claim 2, arranged such that the voltage potential adjuster is operable to isolate electrically the counter-cathode when set to break electrical contact between the cathode and the counter-cathode.

4. An ion source according to claim 1, wherein the voltage potential adjuster is operable to select the potential of the counter-cathode relative to the cathode.

5. An ion source according to claim 4, wherein the voltage potential adjuster comprises at least one of the group comprising a switch, a variable resistor, a power supply and a potential divider.

6. An ion source according to any preceding claim, wherein the cathode is a filament or an end cap of a tube of an indirectly-heated cathode type of ion source.

7. An ion source according to claim 6, further comprising an electron reflector located adjacent the filament of an ion source.

8. An ion source according to any preceding claim, further comprising a magnet assembly arranged to provide a magnetic field in the arc chamber to define the electron path.

9. An ion implanter comprising an ion source according to any of claims 1 to 8, wherein the arc chamber further comprises an exit aperture and the ion implanter further comprises an extraction electrode operable to extract ions from the plasma contained within the arc chamber through the exit aperture, a mass analysis stage located to receive ions extracted from the arc chamber and operable to deliver ions of a selected mass and charge state, at a particular energy, for implanting into a target.

10. A method of operating an ion source according to any of claims 1 to 8, comprising the steps of:
setting potentials across the cathode and anode;
setting the voltage potential adjuster to place a desired potential across the counter-cathode;
filling the arc chamber with gas; and
heating the cathode sufficiently to cause emission of electrons.
